# EUROPÄISCHE PATENTSCHRIFT

(11) **EP 2 066 824 B1**
(45) Veröffentlichungstag und Bekanntmachung des Hinweises auf die Patenterteilung: **28.12.2011**
(21) Anmeldenummer: 07818560.0
(22) Anmeldetag: 28.09.2007
(51) Int. Cl.: C23C 14/35, H01L 31/0224, H01L 31/18

(54) **VERFAHREN ZUR ABSCHEIDUNG EINER OXIDSCHICHT AUF ABSORBERN VON SOLARZELLEN UND VERWENDUNG DES VERFAHRENS**
METHOD FOR DEPOSITING AN OXIDE LAYER ON ABSORBERS OF SOLAR CELLS AND USE OF THE METHOD
PROCÉDÉ POUR LE DÉPÔT D'UNE COUCHE D'OXYDE SUR DES COUCHES ABSORBANTES DE CELLULES SOLAIRES ET UTILISATION DU PROCÉDÉ

(30) Priorität: 29.09.2006 DE 102006046312
(43) Veröffentlichungstag der Anmeldung: 10.06.2009
(73) Patentinhaber: Fraunhofer-Gesellschaft zur Förderung der angewandten Forschung e.V., 80686 München (DE)
(72) Erfinder: SITTINGER, Volker, 38106 Braunschweig (DE); RUSKE, Florian, D-10247 Berlin (DE); SZYSZKA, Bernd, 38108 Braunschweig (DE)
(74) Vertreter: Pfenning, Meinig & Partner GbR
(86) Internationale Anmeldenummer: PCT/EP2007/008480
(87) Internationale Veröffentlichungsnummer: WO 2008/040502

(56) Entgegenhaltungen:
- EP-A- 1 041 644
- JP-A- 1 015 370
- US-B1- 6 468 403

## Beschreibung

Die Erfindung betrifft ein Verfahren zur Abscheidung mindestens eines stabilen, transparenten und leitfähigen Schichtsystems auf Chalkopyrit-Solarzellenabsorber mittels hochionisierender PVD (physical vapour deposition)-Technologie durch High Power Pulsed Magnetron Sputtering (HPPMS) oder High Power Impulse Magnetron Sputtering (HIPIMS).

Gängige Verfahren zur Herstellung von Frontkontakt- und Pufferschichten auf Chalkopyrit-Solarabsorbern (kurz Absorber) leiden unter einer ungenügenden Stabilität des Frontschichtsystems, welches zur Degradation unter Feuchtigkeitseinwirkung, in der Entwicklung getestet durch Damp Heat Tests an unverkapselten Modulen, führt. Die Damp Heat-Stabilität kann anhand von Messungen des Schichtwiderstandes einer Frontkontaktschicht bzw. des Wirkungsgrades der Solarzellen nach Lagerung der Zellen bzw. Schichten bei erhöhter Temperatur und Luftfeuchtigkeit gemessen werden. Grund für die unzureichende Stabilität ist unter anderem die raue Absorberoberfläche. Darauf abgeschiedene Schichten bedecken die Oberfläche nicht vollständig was zu Instabilitäten führt.

Verkapselte Solarmodule auf Basis von Chalkopyrit-Halbleitern mit ZnO:X als transparenter Frontkontakt (X steht für ein Element, wie z.B. Al, Ga, In zum Dotieren des Oxides) zeichnen sich durch hohen Wirkungsgrad und gute Stabilität aus. Diese Module bestehen den Test der künstlichen Alterung bei erhöhter Temperatur und Luftfeuchtigkeit (Damp Heat Test, 85 % Feuchte, 85 °C) und können gemäß EN/IEC 61646 zertifiziert werden. Bei unverkapselten Modulen beobachtet man dagegen eine signifikante Degradation [Klenk, TCO für Dünnschichtsolarzellen und andere Anwendungen I-II, Workshop, Freyburg/Unstrut (2005) S. 71 u. 79]. Die Zunahme der Degradation lässt sich im Wesentlichen auf die Zunahme des Flächenwiderstandes der ZnO:X-Schicht zurückführen [Klaer, Proc. 19th European Photovoltaic Solar Energy Conf., Paris (2004) 1847].

Standardmäßig wird eine CdS-Schicht innerhalb der Chalkopyritsolarzelle zur Herstellung des Heterokontaktes verwendet. CdS besitzt hierfür eine gute Band- und Gitteranpassung. Nachteilig ist die geringe Bandlücke, die zu einem Verlust im Photostrom führt. Die CdS-Schicht wird deshalb relativ dünn (- 40 nm) in Kombination mit einer dicken (- 800 nm) ZnO-Frontkontaktschicht aufgebracht [Potter, Proc. 18th IEEE Photovoltaic Specialists Conf., Las Vegas (1985), 1659]. Dies geschieht mittels der chemischen Badabscheidung (CBD), die eine optimale Bedeckung auch bei sehr dünnen Schichten gewährleistet.

Zur Verbesserung der Stabilität der Solarzelle wird außerdem eine intrinsische ZnO-Schicht (i-ZnO) zwischen CdS und der dotierten ZnO:X-Schicht aufgebracht. Abgesehen von der verbesserten Damp-Heat Stabilität hat die i-ZnO-Schicht keinen Einfluss auf die elektrischen Solarzellenparameter (Ruckh et al. 25th IEEE Photovoltaic Specialists Conf. (1996) 825; Kessler et al. 16th European Photovoltaic Solar Energy Conf. (2000) 775). Man erhält ohne i-ZnO die gleichen Wirkungsgrade (Ramanathan et al. 31th IEEE Photovoltaic Specialists Conf. (2005)).

Lokalisierte Defekte, wie z.B. Pin-holes innerhalb des Absorbers, führen zu Kurzschlüssen, wenn sie in direkten Kontakt mit dem Fronkontakt geraten (Rau 01 et al. Thin Solid Films 387, (2001) 141).

Bisher zeigen unverkapselte Solarmodule nach dem Damp Heat Test eine deutliche Degradation, die hauptsächlich auf Makrokorngrenzen (Hohlräume) zurückzuführen ist, die bei der Abscheidung der TCO-Schichten auf dem rauen Absorber entstehen. So zeigen TCO-Schichten, die auf flachen Substraten, wie Glas oder Silicium, abgeschieden werden, keinerlei Degradation, während Schichten auf texturierten Siliciumwafern bei gleichen Testbedingungen deutliche Degradation zeigen. Dies ist auf die gestörte Mikrostruktur (Hohlräume) des ZnO:X zurückzuführen, die durch die raue Absorberoberfäche verursacht wird (Klenk et al. und Menner et al., TCO für Dünnschichtsolarzellen und andere Anwendungen III, Workshop Freyburg/Unstrut (2005) S. 79, und S. 71).

Von Kouznetsov et al. (Surface and Coating Technologies 122 (1999) 290) wurde gezeigt, dass Strukturen mit hohen Aspektverhältnissen durch hoch ionisierendes Sputtern frei von Hohlräumen hergestellt werden können.

Die Abscheidung einer TCO-Schicht mittels einem gepulsten Magnetronsputterverfahren ist vom Dokument US-B-6 468 403 bekannt.

Ausgehend hiervon ist es Aufgabe vorliegender Erfindung, ein Verfahren bereitzustellen, das die Herstellung von Solarzellen, die Frontkontakt- oder Pufferschichten mit einer verbesserten Stabilität unter Einfluss von Feuchtigkeit und/oder Wärme (Damp Heat-Stabilität) aufweisen, ermöglicht.

Diese Aufgabe wird durch das Verfahren mit den Merkmalen des Patentanspruchs 1 gelöst. Eine Verwendungsmöglichkeit des Verfahrens ist in Patentanspruch 17 beschrieben. Die abhängigen Ansprüche stellen vorteilhafte Weiterbildungen dar.

Erfindungsgemäß wird ein Verfahren zur Abscheidung von mindestens einer transparenten, leitfähigen Oxidschicht auf einer Solarzelle, die mindestens eine Absorberschicht zur Absorption von Licht aufweist, bereitgestellt, wobei die Abscheidung der Oxidschicht mittels einem gepulsten Magnetron-Sputter-Verfahren erfolgt.

Die Pulsfrequenz liegt dabei im Bereich von mindestens 100 Hz, bevorzugt im Bereich 1000 bis 100 Hz, ganz besonders bevorzugt im Bereich 100 bis 500 Hz. Der Dutycycle is kleiner 5 %. Die Pulslängen sind kleiner als 200 µs, besonders bevorzugt 10 bis 200 µs, ganz besonders bevorzugt 30 bis 150 µs. Vorteilhafterweise ist das Sputter-Verfahren dabei ein High Power Pulsed Magnetron Sputtering (HPPMS) und/oder High Power Impulse Magnetron Sputtering (HIPIMS).

Eine Ausführungsform des Verfahrens sieht vor, dass die Leistungsdichte des Partikelstrahls dabei mindestens 0,5 kW/cm², bevorzugt mindestens 0,75 kW/cm², ganz besonders bevorzugt mindestens 1 kW/cm² beträgt.

Durch Verwendung eines derartigen Vakuumdepositionsverfahrens wird ein hoher Ionisationsgrad und/oder eine erhöhte kinetische Energie der schichtbildenden Teilchen beim Auftreffen auf das zu beschichtende Substrat erreicht, wodurch eine erhöhte Beweglichkeit der adsorbierten Spezies auf der Oberfläche des Substrates gewährleistet wird.

Infolge dessen wird die Ausbildung von Defekten, insbesondere das Wachstum von Makrokorngrenzen an den Korngrenzen des zu beschichtenden Absorbers, unterdrückt. Dadurch wird eine erhöhte Stabilität der auf rauen Substraten deponierten TCO-Schicht im Damp Heat-Test erreicht.

Eine verbesserte Damp Heat-Stabilität ist für die industrielle Fertigung von Solarmodulen ein entscheidender vorteil, da die Anforderungen an die Verkapselung der Module reduziert werden können, also Kosten für die Verkapselung eingespart werden können. Insbesondere ist dies bei der Herstellung von Solarmodulen auf flexiblen Substraten, wie z.B. Polymerfolien und Metallfolien von Vorteil, da hier die Verkapselung mit Glas nicht möglich ist, sondern wiederum auf Folien bzw. eine Dünnschichtverkapselung zurückgegriffen werden muss, um die Flexibilität zu wahren.

In einer bevorzugten Ausführungsform wird dabei die Oxidschicht als Frontkontaktschicht der Solarzelle aufgetragen, d.h. die Schicht bildet die abschließende obere Schicht der Solarzelle. Die Frontkontaktschicht kann dabei in einer Dicke 1 nm und 200 nm, bevorzugt zwischen 100 nm und 1,5 µm, bevorzugt zwischen 300 nm und 1000 nm, besonders bevorzugt zwischen 400 nm und 800 nm aufgetragen werden, je nachdem, wie lange der Sputter-Prozess erfolgt.

Vorzugsweise enthält dabei das Material, aus dem die Frontkontaktschicht durch den Sputter-Prozess gebildet wird, Oxide, die aus der Gruppe bestehend aus Zinkoxid, Indiumoxid, Zinnoxid, Zink-Zinn-Mischungen (Stannat), Titanoxid und/oder Mischungen hieraus, gebildet ist.

Zur Erhöhung der Leitfähigkeit und/oder zur Einstellung gezielter elektrischer Eigenschaften ist es dabei weiterhin günstig, wenn die verwendeten oxidischen Materialien dotiert sind. Erfindungsgemäß ist die Dotierung dabei nicht auf spezifische Dotierungsmaterialien beschränkt, sondern kann je nach gewünschtem Ergebnis aus den dem Fachmann bekannten Materialien ausgewählt werden, bevorzugt werden jedoch Aluminium, Gallium, Indium, Bor, Fluor, Antimon, Niob und/oder Mischungen hieraus verwendet. Die Dotierungen werden in dem Fachmann bekannter weise vorgenommen und je nach verwendeter Oxidmatrix ausgewählt. Beispielsweise wird eine Zinkoxidmatrix bevorzugt Al, Ga, In und/oder B als Dotant verwendet. Für eine Indiumoxid-Matrix kommen bevorzugt Zinn (ITO) oder Zink (IZO) in Frage, während eine Zinnoxid wiederum bevorzugt mit den Elementen F und/oder Sb dotiert wird. Titanoxid schließlich wird meist mit Nb als Dotant versehen.

In einer vorteilhaften Weiterbildung beträgt dabei der Dotierungsgrad zwischen 0,2 und 5 Atom-%.

In einer alternativen vorteilhaften Ausführungsform der Erfindung wird die Oxidschicht als Pufferschicht zwischen dem Absorber und einer weiteren, darüber liegenden Schicht, ausgebildet. Erfindungsgemäß ist darunter zu verstehen, dass zunächst die Pufferschicht auf dem Absorber aufgebracht wird und im Anschluss daran mindestens eine weitere Schicht über der Pufferschicht abgeschieden wird, sodass die Pufferschicht zwischen dem Absorber und der weiteren Schicht eingeschlossen wird. Selbstverständlich ist diese alternative Ausführungsform mit den gleichen, für die Aufbringung der Schicht als Frontschicht genannten Vorteilen verbunden.

Prinzipiell sind mit dem erfindungsgemäßen Verfahren beliebige Dicken der Pufferschicht einstellbar, vorteilhafterweise wird die Pufferschicht jedoch in einer Dicke zwischen 1 nm und 200 nm, bevorzugt zwischen 10 und 100 nm, ganz besonders bevorzugt zwischen 10 und 50 nm aufgebracht.

Durch die erhöhte Mobilität der adsorbierten Spezies wird eine vollständige Bedeckung der ausgeprägten dreidimensionalen Struktur des Absorbers auch bei dünnen Pufferschichten (d < 100 nm), insbesondere Schichten mit einer Schichtdicke von weniger als 50 nm, erreicht. Hierdurch wird ein geeigneter Heteroübergang hergestellt.

Insbesondere werden vorteilhafte Ergebnisse dadurch erzielt, wenn die Pufferschicht Materialien, ausgewählt aus der Gruppe bestehend aus Sulfiden und/oder Seleniden der Elemente Indium, Wolfram, Molybdän, Zink, Magnesium, Indiumoxid, Zink-Magnesium-Oxid und/oder Mischungen hieraus enthält. Beispielsweise wird unter einer Mischung Zink-Magnesium-Sulfid und/oder -Selenid verstanden.

Durch Anwendung des erfindungsgemäßen Verfahrens hat sich in Versuchen als weiterer Vorteil herausgestellt, dass auf die Verwendung von Cadmium in der Pufferschicht verzichtet werden kann. Der Verzicht auf die durch chemische Badabscheidung hergestellte CdS-Schicht hat zum Einen den Vorteil, dass bei der Produktion von Solarmodulen eine wesentliche Vereinfachung erreicht wird, da zwischen Herstellung des Absorbers und der TCO-Deposition die Module nicht mehr an Atmosphärendruck gebracht werden müssen. Zum anderen kann durch die Verwendung anderer Materialien auf die Verwendung Cd-haltiger Schichten verzichtet werden.

Das erfindungsgemäße Verfahren ist besonders vorteilhaft anwendbar, wenn die Solarzelle einen Absorber aus Chalkopyrit aufweist. Der Absorber nach der Erfindung umfasst auch PV-Absorber, insbesondere rauhe Absorber, wobei hier auch Dünnschichtabsorber, wie CIGS, CdTe, amorphes Si, mikrokristallines Si oder aus Poly- oder einkristallinem Silizium, umfasst sind.

Erfindungsgemäß wird ebenso eine Solarzelle bereitgestellt, die dadurch gekennzeichnet ist, dass zumindest die Frontkontakt- und/oder die Pufferschicht nach einem Verfahren hergestellt ist, wie vorangehend beschrieben.

Ein erfindungsgemäßer Verwendungszweck des Verfahrens betrifft die Herstellung von Solarzellen.

Die vorliegende Erfindung wird anhand nachfolgenden Beispiels näher beschrieben, ohne die Erfindung auf die dort wiedergegebene spezielle Ausführungsform zu beschränken.

### Beispiel

Zum Test des Verfahrens wurden auf gelieferte Minimodule im Format 10 x 10 cm², mit dem Schicht-Aufbau Glas/Mo/Cu-In-Ga-S-Absorber/CdS/i-ZnO, ZnO:Al-Schichten mittels eines HPPMS-Generators aufgebracht. Die gleichen Absorber wurden gleichfalls vom testenden Institut mit einer optimierten Standard DC gesputterten ZnO:Al-Schicht versehen. Beide Schichten hatten die gleiche ZnO-Al Schichtdicke. Anschließend wurden die hergestellten unverkapselten Minimodule einem Damp Heat-Test (85 % relative Feuchte bei 85 °C) unterzogen.

Die Ergebnisse der Änderung des Flächenwiderstandes bzw. des Wirkungsgrades sind in Tabelle 1 wiedergegeben.

**Tabelle 1**

| Damp Heat Zeit [h] | HPPMS Probe | | DC Referenz Probe | |
|---|---|---|---|---|
| | Rₛₕ [Ω] | η [%] | Rₛₕ [Ω] | η [%] |
| 0 | 7.1 | 12.7 | 12.8 | 12.5 |
| 50 | 8.7 | 10.1 | 18 | 11.9 |
| 212 | 12.4 | 9.2 | 27 | 4.9 |
| 999 | 27.7 | 4.6 | 75.4 | - |

Tabelle 1 zeigt, dass die unter nicht optimierten Bedingungen mittels HPPMS-Technik hergestellte ZnO:Al-Schicht eine verbesserte Damp Heat-Stabilität aufzeigt. Die Prüfung erfolgt nach DIN EN 61646, insbesondere Seite 20.

## Patentansprüche

1. Verfahren zur Abscheidung mindestens einer transparenten, leitfähigen Oxidschicht auf einer Solarzelle, die mindestens eine Absorberschicht aufweist,
mittels einem gepulsten Magnetronsputterverfahren mit einer Pulsfrequenz von mindestens 100 Hz, **dadurch gekennzeichnet, dass** die Leistungsdichte des Partikelstrahls mindestens 0,5 kW/cm² beträgt.

2. Verfahren nach Anspruch 1, **dadurch gekennzeichnet, dass** die Pulsfrequenz im Bereich von 1000 Hz bis 100 Hz, bevorzugt im Bereich von 500 Hz bis 100 Hz liegt.

3. Verfahren nach Anspruch 1 oder 2, **dadurch gekennzeichnet, dass** die Pulslänge ≤ 200 µs, bevorzugt 10 bis 200 µs, besonders bevorzugt 30 bis 150 µs beträgt.

4. Verfahren nach einem der Ansprüche 1 bis 3, **dadurch gekennzeichnet, dass** das Sputterverfahren "High Power Pulsed Magnetron Sputtering" (HPPMS) und/oder "High Power Impulsed Magnetron Sputtering" (HIPIMS) ist.

5. Verfahren nach einem der vorhergehenden Ansprüche, **dadurch gekennzeichnet, dass** die Leistungsdichte des Partikelstrahls mindestens 0,75 kW/cm², bevorzugt mindestens 1 kW/cm² beträgt.

6. verfahren nach einem der vorhergehenden Ansprüche, **dadurch gekennzeichnet, dass** die Oxidschicht als Frontkontaktschicht der Solarzelle aufgetragen wird.

7. Verfahren nach vorhergehendem Anspruch, **dadurch gekennzeichnet, dass** die Frontkontaktschicht in einer Dicke zwischen 100 nm und 1,5 µm, bevorzugt zwischen 300 nm und 1000 nm, besonders bevorzugt zwischen 400 nm und 800 nm aufgebracht wird.

8. Verfahren nach Anspruch 6 oder 7, **dadurch gekennzeichnet, dass** die Frontkontaktschicht Oxide, ausgewählt aus der Gruppe bestehend aus Zinkoxid, Indiumoxid, Zinnoxid, Zink-Zinn-Mischungen (Stannat), Titanoxid und/oder Mischungen hieraus, enthält.

9. Verfahren nach vorhergehendem Anspruch, **dadurch gekennzeichnet, dass** die Oxide dotiert sind.

10. Verfahren nach vorhergehendem Anspruch, **dadurch gekennzeichnet, dass** die Dotierungsmaterialien ausgewählt sind aus der Gruppe bestehend aus Aluminium, Gallium, Indium, Bor, Fluor, Antimon, Niob und/oder Mischungen hieraus.

11. Verfahren nach Anspruch 9 oder 10, **dadurch gekennzeichnet, dass** die Dotierung zwischen 0,2 und 5 Atom-% beträgt.

12. Verfahren nach einem der Ansprüche 1 bis 5, **dadurch gekennzeichnet, dass** die Oxidschicht als Pufferschicht zwischen dem Absorber und einer weiteren, darüber liegenden Schicht aufgebracht wird.

13. Verfahren nach Anspruch 12, **dadurch gekennzeichnet, dass** die Pufferschicht in einer Dicke zwischen 1 nm und 200 nm, bevorzugt zwischen 10 und 100 nm, ganz besonders bevorzugt zwischen 10 und 50 nm aufgebracht wird.

14. Verfahren nach einem der Ansprüche 12 bis 13, **dadurch gekennzeichnet, dass** die Pufferschicht Materialien, ausgewählt aus der Gruppe bestehend aus Sulfiden und/oder Seleniden der Elemente Indium, Wolfram, Molybdän, Zink, Magnesium, Indiumoxid, Zink-Magnesium-Oxid und/oder Mischungen hieraus enthält.

15. Verfahren nach einem Ansprüche 12 bis 14, **dadurch gekennzeichnet, dass** die Pufferschicht Cadmium frei ist.

16. Verfahren nach einem der vorhergehenden Ansprüche, **dadurch gekennzeichnet, dass** die Solarzelle einen Absorber, bevorzugt einen Dünnschichtabsorber, aus CIGS, cdTe, amorphem Si, mikrokristallinem Si oder aus Poly- oder einkristallinem Silizium aufweist.

17. Verwendung des Verfahrens nach einem der Ansprüche 1 bis 16 zur Herstellung von Solarzellen.

## Claims

1. Method for depositing at least one transparent, conductive oxide layer on a solar cell, which comprises at least one absorber layer, by means of a pulsed magnetron sputtering process with a pulse frequency of at least 100 Hz, **characterized in that** the power density of the particle beam is at least 0.5 kW/cm².

2. Method according to claim 1, **characterized in that** the pulse frequency is in the range of from 1,000 Hz to 100 Hz, preferably in the range of from 500 Hz to 100 Hz.

3. Method according to claim 1 or 2, **characterized in that** the pulse length is ≤ 200 µs, preferably 10 to 200 µs, particularly preferably 30 to 150 µs.

4. Method according to one of claims 1 to 3, **characterized in that** the sputtering process is high power pulsed magnetron sputtering (HPPMS) and/or high power impulsed magnetron sputtering (HIPIMS).

5. Method according to one of the preceding claims, **characterized in that** the power density of the particle beam is at least 0.75 kW/cm², preferably at least 1 kW/cm².

6. Method according to one of the preceding claims, **characterized in that** the oxide layer is applied as the front contact layer of the solar cell.

7. Method according to the preceding claim, **characterized in that** the front contact layer is applied in a thickness of between 100 nm and 1.5 µm, preferably between 300 nm and 1,000 µm, particularly preferably between 400 nm and 800 nm.

8. Method according to claim 6 or 7, **characterized in that** the front contact layer contains oxides chosen from the group consisting of zinc oxide, indium oxide, tin oxide, zinc/tin mixtures (stannate), titanium oxide and/or mixtures of these.

9. Method according to the preceding claim, **characterized in that** the oxides are doped.

10. Method according to the preceding claim, **characterized in that** the doping materials are chosen from the group consisting of aluminium, gallium, indium, boron, fluorine, antimony, niobium and/or mixtures of these.

11. Method according to claim 9 or 10, **characterized in that** the doping is between 0.2 and 5 atom%.

12. Method according to one of claims 1 to 5, **characterized in that** the oxide layer is applied as a buffer layer between the absorber and a further layer lying over this.

13. Method according to claim 12, **characterized in that** the buffer layer is applied in a thickness of between 1 nm and 200 nm, preferably between 10 and 100 nm, very particularly preferably between 10 and 50 nm.

14. Method according to one of claims 12 to 13, **characterized in that** the buffer layer contains materials chosen from the group consisting of sulphides and/or selenides of the elements indium, tungsten, molybdenum, zinc, magnesium, indium oxide, zinc magnesium oxide and/or mixtures of these.

15. Method according to one of claims 12 to 14, **characterized in that** the buffer layer is cadmium-free.

16. Method according to one of the preceding claims, **characterized in that** the solar cell comprises an absorber, preferably a thin layer absorber, of CIGS, cdTe, amorphous Si, microcrystalline Si or of poly- or monocrystalline silicon.

17. Use of the method according to one of claims 1 to 16 for the production of solar cells.

## Revendications

1. Procédé pour le dépôt d'au moins une couche d'oxyde conductrice transparente sur une cellule solaire, qui comprend au moins une couche absorbante, par un procédé de pulvérisation cathodique magnétron, ayant une fréquence d'impulsion d'au moins 100 Hz, **caractérisé en ce que** la densité de puissance du faisceau de particules est d'au moins 0,5 kW/cm².

2. Procédé selon la revendication 1, **caractérisé en ce que** la fréquence d'impulsion est comprise dans une plage allant de 1 000 Hz à 100 Hz, de préférence dans une plage allant de 500 Hz à 100 Hz.

3. Procédé selon la revendication 1 ou 2, **caractérisé en ce que** la longueur de l'impulsion est ≤ 200 µs, de préférence de 10 à 200 µs, d'une manière particulièrement préférée de 30 à 150 µs.

4. Procédé selon l'une des revendications 1 à 3, **caractérisé en ce que** le procédé de pulvérisation cathodique est le "High Power Pulsed Magnetron Sputtering" (HPPMS) et/ou le "High Power Impulsed Magnetron Sputtering" (HIPIMS).

5. Procédé selon l'une des revendications précédentes, **caractérisé en ce que** la densité de puissance du faisceau de particules est d'au moins 0,75 kW/cm², de préférence d'au moins 1 kW/cm².

6. Procédé selon l'une des revendications précédentes, **caractérisé en ce que** la couche d'oxyde est appliquée en tant que couche de contact frontale de la cellule solaire.

7. Procédé selon la revendication précédente, **caractérisé en ce que** la couche de contact frontale est appliquée avec une épaisseur comprise entre 100 nm et 1,5 µm, de préférence entre 300 nm et 1 000 nm, d'une manière particulièrement préférée entre 400 nm et 800 nm.

8. Procédé selon la revendication 6 ou 7, **caractérisé en ce que** la couche de contact frontale contient des oxydes choisis dans le groupe consistant en l'oxyde de zinc, l'oxyde d'indium, l'oxyde d'étain, les mélanges zinc-étain (stannate), l'oxyde de titane et/ou les mélanges de ceux-ci.

9. Procédé selon la revendication précédente, **caractérisé en ce que** les oxydes sont dopés.

10. Procédé selon la revendication précédente, **caractérisé en ce que** les matériaux de dopage sont choisis dans le groupe consistant en l'aluminium, le gallium, l'indium, le bore, le fluor, l'antimoine, le niobium et/ou les mélanges de ceux-ci.

11. Procédé selon la revendication 9 ou 10, **caractérisé en ce que** le dopage est compris entre 0,2 et 5 % en atomes.

12. Procédé selon l'une des revendications 1 à 5, **caractérisé en ce que** la couche d'oxyde est appliquée en tant que couche tampon entre l'absorbeur et une autre couche, disposée par-dessus.

13. Procédé selon la revendication 12, **caractérisé en ce que** la couche tampon est appliquée avec une épaisseur comprise entre 1 nm et 200 nm, de préférence entre 10 et 100 nm, d'une manière tout particulièrement préférée entre 10 et 50 nm.

14. Procédé selon l'une des revendications 12 à 13, **caractérisé en ce que** la couche tampon contient des matériaux choisis dans le groupe consistant en les sulfures et/ou les séléniures des éléments indium, tungstène, molybdène, zinc, magnésium, l'oxyde d'indium, l'oxyde de zinc et de magnésium et/ou les mélanges de ceux-ci.

15. Procédé selon l'une des revendications 12 à 14, **caractérisé en ce que** la couche tampon est exempte de cadmium.

16. Procédé selon l'une des revendications précédentes, **caractérisé en ce que** la cellule solaire comprend un absorbeur, de préférence un absorbeur à couche mince, en CIGS, cdTe, Si amorphe, Si microcristallin, ou en silicium poly- ou monocristallin.

17. Utilisation du procédé selon l'une des revendications 1 à 16 pour fabriquer des cellules solaires.
